Europäisches Patentamt

European Patent Office

Office européen des brevets

(11) Publication number: **0 330 743**
A2

(12) # EUROPEAN PATENT APPLICATION

(21) Application number: **88120022.4**

(51) Int. Cl.⁴: **G11C 11/44**

(22) Date of filing: **30.11.88**

(30) Priority: **29.02.88 JP 47051/88**

(43) Date of publication of application:
**06.09.89 Bulletin 89/36**

(84) Designated Contracting States:
**DE FR**

(71) Applicant: **NEC HOME ELECTRONICS, LTD.**
**5-24, Miyahara 3-chome Yodogawa-ku**
**Osaka-shi Osaka(JP)**

(72) Inventor: **Ito, Susumu**
**Nec Home Electronics Ltd. No.5-24,Miyahara**
**3-chome**
**Yodogawa-ku Osaka-shi Osaka(JP)**

(74) Representative: **DIEHL GLAESER HILTL &**
**PARTNER**
**Patentanwälte Flüggenstrasse 13**
**D-8000 München 19(DE)**

(54) **Dynamic random access memory (RAM).**

(57) A dynamic RAM (30) comprises: a plurality of superconducting rings (S1...Sn) arranged in a line with the adjacent rings (S1,S2;...;Sn-1,Sn) partially superposed one above another; a driving circuit (12) connected to the superconducting rings (S1...Sn) through an input portion (14); and a detection circuit (18) connected to the rings (S1...Sn) through an output portion (16). In response to a current signal (io) inputted from the driving circuit (12), currents (i1...in)are successively induced in the superconducting rings (S1...Sn) through magnetic flux and detected by the detection circuit (18). Information can be stored by recycling the current signal in a loop including the superconducting rings (S1...Sn).

Fig. 1

## DYNAMIC RANDOM ACCESS MEMORY (RAM)

The present invention relates to a memory device, and more specifically, relates to a dynamic RAM (Random Access Memory).

A conventional dynamic RAM consists of MOS (Metal-Oxide-Semiconductor) transistors and capacitors, and stores information by charging the capacitors. The information can be written-into and read-out of the dynamic RAM. Since the dynamic RAM can be highly integrated, it is now widely used in computers as their main memory devices.

In the dynamic RAM, as the information is stored by charging the capacitors, it is necessary to re-write the information in every predetermined period to prevent the information from disappearing through discharging of the capacitors. Therefore, a relatively large amount of electric power is dissipated in the dynamic RAM (power consumption in the MOS transistors, charging of the capacitors, etc.). Moreover, a problem in the conventional dynamic RAM is the difficulty to increase the integration density thereof because of the problems in making multi-layered single crystals which are used to form transistors therein. A further problem is that the conventional dynamic RAM requires highly sophisticated techniques in its manufacturing processes, because complicated circuits must be formed in a minute area.

An object of the present invention is to solve the above-described problems. This object is solved by the dynamic RAM as disclosed in the independent claims. Further advantageous features of the RAM are evident from the dependent claims.

The invention also provides a dynamic RAM with low power consumption and high integration density.

A dynamic RAM according to the present invention comprises: a plurality of superconducting rings arranged in a line with the adjacent rings being partially placed one above another; an input portion which is partially placed above or below an end ring of the plurality of superconducting rings; a driving circuit connected to the input portion, for providing the input portion with a signal current; an output portion which is partially placed above or below the other end ring of the plurality of superconducting rings; and a detection circuit whose input-side and output-side are connected to the output portion and an input-side of the driving circuit, respectively, for detecting a current flowing through the output portion.

Currents are successively induced in the superconducting rings through magnetic flux and detected by the detection circuit. Information can be stored by recycling the current signal in a loop including the superconducting rings.

The dynamic RAM according to the invention, stores information with being rewritten in every predetermined period.

Other and further objects, features and advantages of the invention will appear more fully from the following description taken in connection with the accompanying drawings.

Fig. 1 illustrates a memory cell which constitutes a dynamic RAM according to an embodiment of the present invention; and

Fig. 2 illustrates a dynamic RAM according to another embodiment of the invention.

Preferred embodiments of the present invention will be hereinafter described with reference to the accompanying drawings.

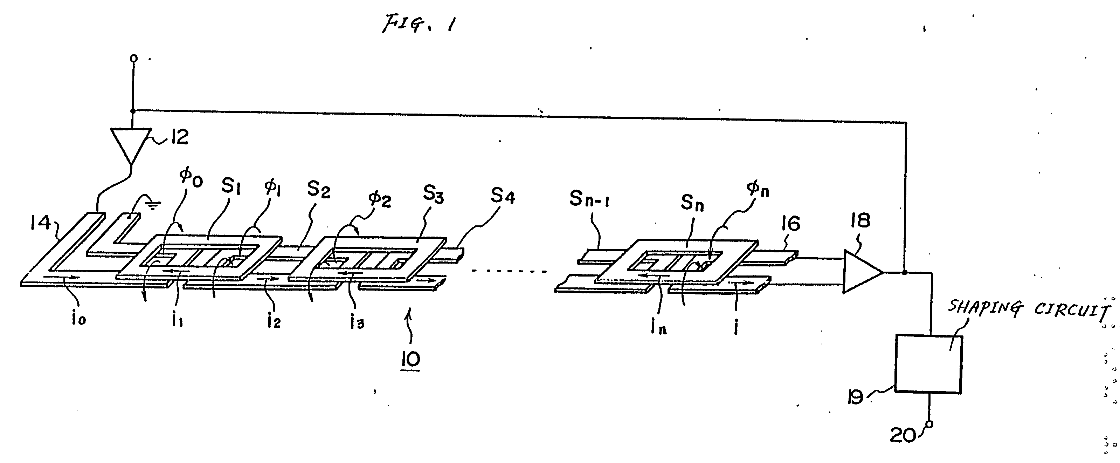

Fig. 1 illustrates an embodiment of a memory cell which is used in a dynamic RAM according to the invention.

In a memory cell 10 of a dynamic RAM as shown in Fig. 1, an output-side of an amplifier 12 which constitutes a driving circuit is connected to an input portion 14. The input portion 14 is composed of a conducting or superconducting material and has such a structure as a loop partially cut out. One end of the cut-out portion of the loop is connected to the output-side of the amplifier 12 and the other end of the loop is connected to the ground. Part of a frame-like superconducting ring $S_1$ is placed above rectangular part of the input portion 14 through an insulation layer (not shown). Below the superconducting ring $S_1$ is formed a frame-like superconducting ring $S_2$ with parts of the two rings being superposed one above another. The superconducting ring $S_2$ and the input portion 14 are formed in the same plane and there exists a spacing therebetween.

Another superconducting ring $S_3$ is formed in a plane in which the superconducting ring $S_1$ is located, in such a manner that the ring $S_3$ is partially placed above the ring $S_2$ and there exists a spacing between the rings $S_1$ and $S_3$. In the same manner, remaining superconducting rings are alternately formed in the plane of the input portion 14 and the ring $S_2$ and in the plane of the rings $S_1$ and $S_3$ with parts of the adjacent rings being superposed one above another.

Below an end superconducting ring $S_n$ is formed an output portion 16 having a shape of cut-out rectangular loop with parts of those being superposed one above another. The output portion 16 is composed of a conducting or superconducting material, which is the same as the input portion 14, and is connected to an input-side of an amplifier 18 which constitutes a detection circuit.

An output-side of the amplifier 18 is not only connected to an output terminal 20 through a shaping circuit 19, but also connected to the input side of the amplifier 12 of the driving circuit.

A manufacturing method of the above memory cell 10 will be hereinafter described.

A layer of superconducting material is formed on a glass or silicon substrate by vacuum deposition or sputtering. It should be noted that as the superconducting material there can be used niobium (Nb), lead (Pb), etc. which take the superconducting state at extremely low temperatures and ceramics such as so called an yttrium group (Y-Ba-Cu-O) which takes the superconducting state at the liquid nitrogen temperature.

After the layer of the superconducting material has been formed on the substrate, the input portion 14, the superconducting rings $S_2$, $S_4$, ... $S_{n-1}$, and the output portion 16 are formed by masking processes and by etching processes. Next, an insulation layer of $SiO_2$, $Si_3N_4$, etc. is formed on the above-formed superconducting rings. Then, after the other layer of superconducting material has been formed on the insulation layer, the rings $S_1$, $S_3$, ... $S_n$ are formed by the masking and etching processes. Finally, a protection film is formed on the second superconducting rings.

Such circuits as the amplifiers 12 and 18 can be formed in the silicon substrate by the conventional method. In this case, a GaAs IC which operates in liquid helium is employed when the above-described superconducting material is niobium, lead, etc.

Now, the operation of the memory cell 10 thus manufactured will be described in the following.

As shown in Fig. 1, when a current $i_0$ of the type of sine wave, rectangular wave, or triangular wave is applied to the input portion 14 through the amplifier 12 of the driving circuit, a magnetic flux $\Phi_0$ is generated. The flux $\Phi_0$ becomes strong in accordance with the increase of the current $i_0$. Corresponding to the generation and increase of the magnetic flux $\Phi_0$, a current $i_1$ is induced in the superconducting ring $S_1$ in such a direction that magnetic flux $\Phi_1$ which corresponds to the current $i_1$ cancels the magnetic flux $\Phi_0$. In the ring $S_2$, a current $i_2$ is induced in such a direction that a magnetic flux $\Phi_2$ which corresponds to the current $i_2$ cancels the generation and increase of the magnetic flux $\Phi_1$. In the same manner, induced currents are successively generated in the respective superconducting rings one after another, so that a current $i_n$ is induced in the ring $S_n$ and the corresponding magnetic flux $\Phi_n$ is generated. Finally, a current $i$ is induced in the output portion 16.

When the current $i_0$ flowing in the input portion 14 starts to decrease, the corresponding magnetic flux $\Phi_0$ also starts to decrease. In the ring $S_1$ the current $i_1$ has the reverse direction from that in the above-described case to cancel the decrease of the flux $\Phi_0$. In this manner, currents with the reverse direction from those in the above-described case are induced in the superconducting rings $S_2$ to $S_n$ and the output portion 16.

The current $i$ flowing through the output portion 16 is amplified by the amplifier 18, provided to the shaping circuit 19, and outputted from the output terminal 20 as, for example, a rectangular wave. The information can be read out by, for example, designating the pulse corresponding to the current with the direction of Fig. 1 as "1" and the pulse corresponding to the current with the reverse direction as "0".

The information can be stored in the memory cell 10 by feeding-back the output of the amplifier 18 to the input-side of the amplifier 12 and recycling the current along such a loop as the amplifier 12 → the input portion 14 → the superconducting rings $S_1$ to $S_n$ → the output portion 16 → the amplifier 18 → the amplifier 12. The information consisting of 4 bits, 8 bits, etc. can be stored in the recycling loop by providing the input portion 14 with a current signal $i_0$ of pulses with a prescribed number and an interval before the output signal of the amplifier 18 corresponding to the current signal previously applied to the input portion 14 is fed-back to the amplifier 12. The dynamic RAM can be constructed by arranging a number of memory cells 10 in a plane and connecting an address buffer, etc. to the memory cells 10.

Since in the foregoing memory cell 10 the currents are successively induced in the plural superconducting rings whose adjacent rings are partially superposed one above another and the signal is recycled in the loop, there occurs no current dissipation in the superconducting rings, so that the dynamic RAM with extremely smaller power consumption than the conventional dynamic RAM can be obtained. Furthermore, with this embodiment, as the superconducting rings are formed by simply stacking the superconducting materials, they can be manufactured more easily than the conventional dynamic RAM.

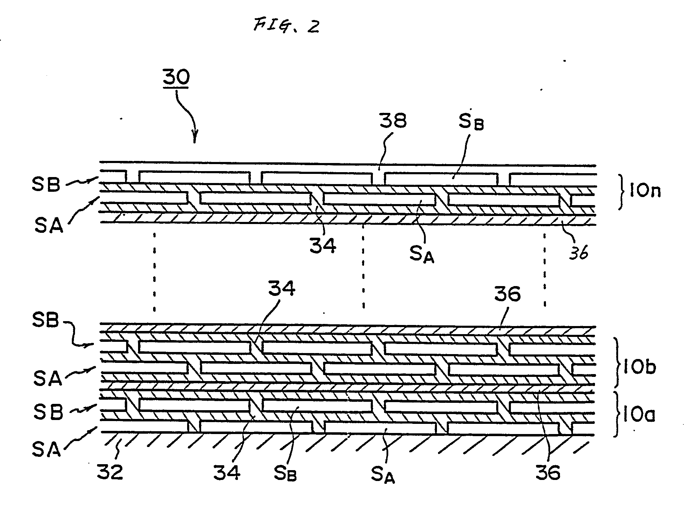

Fig. 2 illustrates another embodiment according to the present invention.

As shown in Fig. 2, a dynamic RAM 30 is formed by stacking a plurality of memory cells 10a, 10b, ... 10n on a substrate 32. Each of memory cells 10a, 10b, ... 10n consists of a bottom array SA and a top array SB of superconducting rings. The two arrays SA and SB are insulated from each other by an insulation layer 34 disposed therebetween. A superconducting ring $S_A$ of the ring array SA and a superconducting ring $S_B$ of the ring array SB are partially superposed one above another. Also formed is a superconducting layer 36 between the adjacent memory cells. The bottom ring array SA of the memory cell 10a is formed on the substrate 32, and the top ring array SB of the memory cell 10n is covered with a protection film 38.

Each of the memory cells 10a, 10b, ... 10n has an input portion, an output portion, amplifiers, etc. in the same manner as the memory cell 10 shown in Fig. 1.

In the dynamic RAM 30 thus constructed, as the superconducting layer 36 is disposed between the adjacent memory cells, the magnetic flux generated by the current flowing through each superconducting ring of one memory cell is confined within that memory cell by the existence of the superconducting layer 36, so that the other cells are not influenced by that magnetic flux. Therefore, each memory cell can accurately store the information without receiving any undesirable influence from outside and can be prevented from malfunctioning.

In contrast with the conventional dynamic RAM which uses semiconductors, the multilayed cells with superconducting rings can be stacked in the dynamic RAM 30 of this embodiment. Stacking density of the cells can be increased relatively easily.

Even compared with the Josephson memory which also utilizes the superconducting material, the dynamic RAM 30 of this embodiment has a simpler structure and therefore can realize higher integration density.

It is further preferable to form a superconducting layer between the memory cell 10a and the substrate 32 and above the memory cell 10n. With this structure, the magnetic flux does not leak from the dynamic RAM 30, so that the dynamic RAM 30 can be prevented from giving undesirable influence to the external devices. Moreover, if the dynamic RAM 30 is composed of so called "high temperature superconducting materials", it can be used in the same manner as the conventional dynamic RAM, as well as in the liquid helium or in the liquid nitrogen.

## Claims

1. A dynamic RAM (30) comprising a plurality of memory cells (10a...10n) each of said plurality of memory cells (10a...10n) comprising:
a plurality of superconducting rings (S1.. ..Sn) with adjacent superconducting rings (S1,S2;S2,S3; ....; Sn-1,Sn) being partially superposed one above another;
an input portion (14) which is partially placed above or below a first end ring (S1) of said plurality of superconducting rings (S1...Sn);

a driving circuit (12) connected to said input portion (14) for providing said input portion (14) with a signal current;
an output portion (16) which is partially placed above or below a second end ring (Sn) of said plurality of superconducting rings (S1...Sn), and
a detection circuit (18) whose input-side and output-side are connected to said output portion (16) and input-side of said driving circuit (12), respectively, for detecting a signal current flowing through said output portion (18).

2. A dynamic RAM as claimed in Claim 1, wherein said plurality of superconducting rings (S1....Sn) are alternately included in a first array (SA) and in a second array (SB) and each of said plurality of memory cells (10a...10n) further comprising an insulation layer (34) disposed between said first (SA) and second (SB) array of superconducting rings (S1...Sn).

3. A dynamic RAM as claimed in claim 1 or 2, wherein said plurality of memory cells (10a...10n) are formed in a plane.

4. A dynamic RAM as claimed in one of the preceding claims, said dynamic RAM further comprising a substrate (32), wherein
said plurality of memory cells (10a... 10n) are formed on said substrate (32) with being stacked in a direction perpendicular to said substrate (32).

5. A dynamic RAM as claimed in Claim 4, said dynamic RAM further comprising a superconducting layer (36) between adjacent memory cells (10a,10b; ...;10n-1,10n).

6. A dynamic RAM as claimed in Claim 4 or 5, said dynamic RAM further comprising superconducting layers between said substrate (32) and a bottom memory cell (10a) and above a top memory cell (10n).

FIG. 1

## FIG. 2